# EUROPEAN PATENT APPLICATION

(11) **EP 4 050 796 A1**
(43) Date of publication of application: **31.08.2022**
(21) Application number: 20880311.4
(22) Date of filing: 06.05.2020
(51) Int. Cl.: H03H 9/17

(54) **BULK ACOUSTIC WAVE RESONATOR AND MANUFACTURING METHOD THEREFOR, FILTER, AND ELECTRONIC DEVICE**

(30) Priority: 26.10.2019 CN 201911027014
(71) Applicant: ROFS MICROSYSTEM (TIANJIN) CO., LTD., Tianjin 300462 (CN)
(72) Inventor: PANG, Wei, Tianjin 300072 (CN); XU, Yang, Tianjin 300462 (CN); HAO, Long, Tianjin 300072 (CN); ZHANG, Menglun, Tianjin 300072 (CN); YANG, Qingrui, Tianjin 300072 (CN)
(74) Representative: Meyer-Dulheuer MD Legal Patentanwälte PartG mbB
(86) International application number: PCT/CN2020/088663
(87) International publication number: WO 2021/077713

(57) **Abstract**

Disclosed is a bulk acoustic wave resonator, including: a substrate; an acoustic mirror; a top electrode; a bottom electrode; and a piezoelectric layer disposed between the bottom electrode and the top electrode, wherein the overlapping region of the top electrode, the bottom electrode, the acoustic mirror, and the piezoelectric layer in the thickness direction of the resonator defines the effective region of the resonator. The bottom electrode and/or the top electrode are gap electrodes. The gap electrode has a first electrode and a second electrode. The first electrode is attached to the piezoelectric layer. A gap layer is defined between the first electrode and the second electrode. The resonator is located between the first and second electrodes in the height direction of the resonator. The gap electrode is provided with a release channel for forming the gap layer. The release channel is communicated with the gap layer. The release channel includes an electrode channel portion which is provided in a non-effective region of the electrode. The present invention also relates to a filter having the resonator and an electronic device having the filter or the resonator, and a method for manufacturing the resonator.

## Description

### TECHNICAL FIELD

Embodiments of the present disclosure relate to the field of semiconductors, and in particular, to a bulk acoustic wave resonator and a manufacturing method therefor, a filter having the resonator, and an electronic device having the resonator or the filter.

### BACKGROUND

Electronic components have been widely used as basic elements of electronic devices, applications of which include mobile phones, vehicles, household appliances and so on. In addition, technologies such as artificial intelligence, Internet of Things and 5G communications that will change the world in the future still need to rely on the electronic components as foundations.

The electronic components can exert different characteristics and advantages according to different working principles. Among all electronic components, components that use a piezoelectric effect (or an inverse piezoelectric effect) for working are an important type of electronic components. Piezoelectric devices have very wide applications. A film bulk acoustic resonator (FBAR, also referred to as Bulk Acoustic Wave Resonator, BAW), as an important member of the piezoelectric devices, is important in the field of communications. In particular, FBAR filters have an increasing market in the field of radio frequency (RF) filters. The FBAR has excellent characteristics such as small size, high resonant frequency, high quality factor, large power capacity, and good roll-off effect. The filters of FBAR are gradually replacing traditional surface acoustic wave (SAW) filters and ceramic filters. The filters of FBAR play a huge role in the field of wireless communication radio frequency, and the high sensitivity advantage thereof can be applied to biological, physical, medical and other sensing fields.

The structural main body of the film bulk acoustic wave resonator is a "sandwich" structure composed of electrode-piezoelectric film-electrode, that is, a piezoelectric material is sandwiched between two metal electrode layers. By inputting a sinusoidal signal between the two electrodes, the FBAR converts the input electrical signal into mechanical resonance by the inverse piezoelectric effect, and converts the mechanical resonance into an electrical signal for output by the piezoelectric effect.

It is very complicated to integrate an air gap in a micro-structure of the bulk acoustic wave resonator. On one hand, it is necessary to consider how to manufacture the air gap reliably, and on the other hand, it is necessary to consider that the way/structure of forming the air gap cannot affect the performance of the resonator.

### SUMMARY

The present disclosure is provided to alleviate or solve the above problems.

According to one aspect of embodiments of the present disclosure, a bulk acoustic wave resonator is provided and includes a substrate, an acoustic mirror, a top electrode, a bottom electrode, and a piezoelectric layer provided between the bottom electrode and the top electrode. The top electrode, the bottom electrode, the acoustic mirror and the piezoelectric layer overlap with each other in a thickness direction of the resonator to form an overlapping region, which defines an effective region of the resonator. The bottom electrode and/or the top electrode is a gap electrode. The gap electrode includes a first electrode and a second electrode, the first electrode is attached to the piezoelectric layer, and a gap layer is provided between the first electrode and the second electrode. The gap layer is located between the first electrode and the second electrode in a height direction of the resonator. The gap electrode is provided with at least one release channel to form the gap layer. The at least one release channel communicates with the gap layer, and includes an electrode channel portion provided in a non-effective region of the electrode.

The present disclosure further provides a method for manufacturing the above bulk acoustic wave resonator. The method includes: forming a sacrificial layer material between the first electrode and the second electrode, the sacrificial layer material being arranged between the first electrode and the second electrode in the thickness direction of the resonator; providing the at least one release channel; and etching, by using an etchant, the sacrificial layer material through the at least one release channel to form the gap layer.

The embodiments of the present disclosure also relate to a filter including the above bulk acoustic wave resonator.

The embodiments of the present disclosure also relate to an electronic device including the above filter or the above resonator.

### BRIEF DESCRIPTION OF DRAWINGS

The following description and drawings can help understand these and other features and advantages in various embodiments of the present disclosure. The same reference signs in the drawings always indicate the same components, wherein:
Fig. 1A is a top view of a process structure of a bulk acoustic wave resonator according to an exemplary embodiment of the present disclosure, in which a top electrode is provided with an air gap;
Fig. 1B is a sectional view of a process structure of a bulk acoustic wave resonator along a straight line A1-A2 in Fig. 1A according to an exemplary embodiment of the present disclosure, in which a top electrode is provided with an air gap, and a sacrificial hole provided in the top electrode is not shown in Fig. 1B;
Fig. 1C is a sectional view of a bulk acoustic wave resonator along a straight line A1-A2 in Fig. 1A according to an exemplary embodiment of the present disclosure, in which a top electrode is provided with an air gap, an etching process structure is utilized, an arrow direction indicates that an etchant enters the air gap from the outside through channels, and a sacrificial hole provided in a non-pin end of the top electrode is not shown in Fig. 1C;
Fig. 2A is a sectional view of a process structure of a bulk acoustic wave resonator according to an exemplary embodiment of the present disclosure, in which a bottom electrode is provided with an air gap;
Fig. 2B is a sectional view of a process structure of a bulk acoustic wave resonator according to an exemplary embodiment of the present disclosure, in which a bottom electrode is provided with an air gap;
Fig. 3A is a top view of a bulk acoustic wave resonator according to an exemplary embodiment of the present disclosure, in which a bottom electrode is provided with an air gap;
Fig. 3B is a sectional view of a process structure of a bulk acoustic wave resonator according to an exemplary embodiment of the present disclosure, in which a bottom electrode is provided with an air gap; and
Fig. 4 is a sectional view of a process structure of a bulk acoustic wave resonator according to an exemplary embodiment of the present disclosure, in which a bottom electrode is provided with an air gap.

### DESCRIPTION OF EMBODIMENTS

The technical solutions of the present disclosure will be further described in detail below through embodiments and in conjunction with the drawings. In the specification, the same or similar reference signs refer to the same or similar components. The following description of the embodiments of the present disclosure with reference to the drawings is intended to explain the general inventive concept of the present disclosure, and should not be construed as a limitation to the present disclosure.

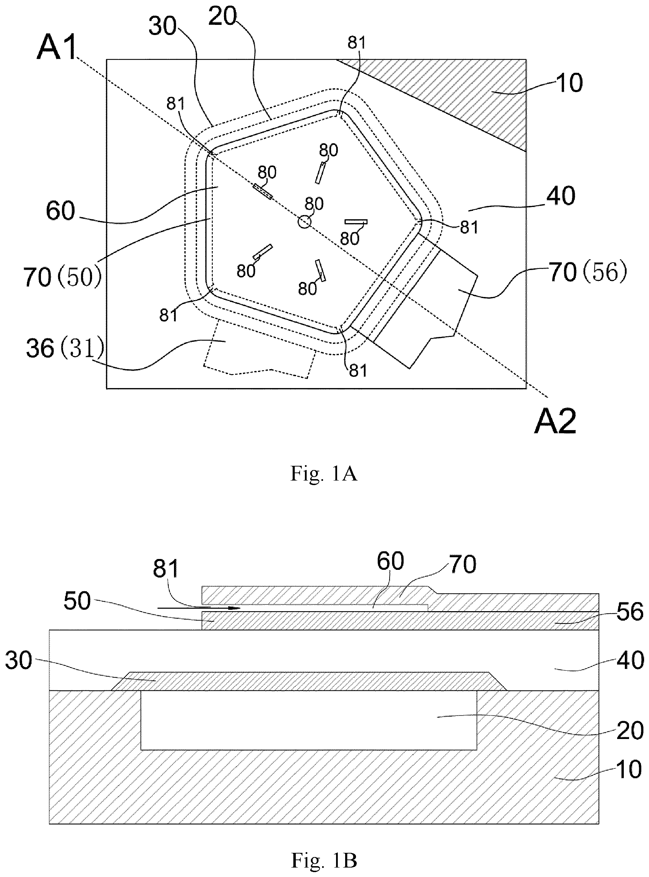

In the drawings of the present disclosure, the reference signs are described as follows:
10: a substrate typically made of silicon (high-resistance silicon), gallium arsenide, sapphire, quartz or the like;
20: an acoustic mirror, which is a cavity 20 in Fig. 1B, or may employ a Bragg reflection layer or other equivalent forms, but in the case where a bottom electrode is provided with an etching channel, the acoustic mirror has a cavity structure;
30: a first bottom electrode, a material of which is selected from molybdenum, ruthenium, gold, aluminum, magnesium, tungsten, copper, titanium, iridium, osmium or chromium, or a compound or an alloy thereof;
36: an electrode pin, a material of which is the same as that of the first bottom electrode;
31: a second bottom electrode, a material of which is selected from the same material range as that of the first bottom electrode 30, but the material may not be the same as that of the first bottom electrode 30;
40: a piezoelectric film layer, which may be made of aluminum nitride (AlN), zinc oxide (ZnO), lead zirconate titanate (PZT), lithium niobate (LiNbO₃), quartz, potassium niobate (KNbO₃), lithium tantalate (LiTaO₃) or the like, and may contain rare earth element doped materials with a certain atomic ratio of the above materials;
50: a first top electrode, which may be made of molybdenum, ruthenium, gold, aluminum, magnesium, tungsten, copper, titanium, iridium, osmium or chromium, or a compound or an alloy thereof;
56: an electrode pin, a material of which is the same as that of the first top electrode;
60: an air gap formed in the top electrode and arranged between the first top electrode 50 and a second top electrode 70;
70: the second top electrode, a material of which is selected from a same material range as that of the first top electrode 50, but the material may not be the same as that of the first top electrode 50;
80: sacrificial holes penetrating through the second top electrode 70 and communicating with the air gap 60; and
81: sacrificial holes, which may be gap holes between non-pin ends of the first top electrode and the second top electrode, and the sacrificial holes 81 communicate with the air gaps 60.

It should be noted that the air gap constitutes a gap layer. However, in the present disclosure, the gap layer is a vacuum gap layer except for the air gap layer, or is a gap layer filled with other gas media.

However, it is not easy to integrate an air gap in a micro-structure. On one hand, it is required to consider how to manufacture the air gap reliably, and on the other hand, it is required to consider that the way/structure of forming the air gap cannot affect the performance of the resonator.

In the present disclosure, a method for manufacturing the air gap inside the electrode is to deposit a sacrificial film and then remove it, which mainly involves how to arrange the sacrificial hole.

First, the sacrificial holes are located outside an active region in a lateral direction of the resonator, which does not affect the performance of the resonator. If a distance from the acoustic active region is too far to effectively etch the sacrificial film. For example, the sacrificial holes 80 are located in an additional electrode (an electrode layer of the gap electrode away from the piezoelectric layer), because the sacrificial holes 80 are located outside the acoustic active region composed of the top electrodes, the piezoelectric layer, the bottom electrodes and the like, the acoustic resonance performance is not affected.

Second, the arrangement of the sacrificial holes may affect the electrical performance and reliability of the resonator. For example, the sacrificial holes 80 and 81 are provided to reduce the number of holes and a total area of holes as much as possible on the premise of guaranteeing effective sacrifice. An unreasonable arrangement will result in a decrease in the conductivity of the additional electrode (for example, corresponding to the second top electrode) 70, cannot effectively improve a Q value at a series resonance point, or result in a decrease in the reliability of the additional electrode 70.

In the present disclosure, the air gap structure in the electrode is made by a process of providing a sacrificial layer material and releasing an etchant. The sacrificial layer may be made of phosphorus-doped silicon dioxide (PSG), the etchant can be selected from liquid or gaseous hydrofluoric acid, and the etchant may be mixed with a certain proportion of buffering substances to control the reaction rate.

Specifically, the top electrodes (and/or the bottom electrodes) of the bulk acoustic wave resonator shown in Fig. 1A has a composite structure. In a first embodiment, a plurality of through holes 81 is provided between the first top electrode 50 and the second top electrode 70. In a second embodiment, a plurality of through holes 80 is provided in the second top electrode 70.

It should be noted that the above structures in the first and second embodiments are independent embodiments, which can be applied to the resonator at the same time or be applied to the resonator separately.

An etching reaction starts from openings of the through holes 80 and/or 81 during processing. As the reaction proceeds, the etchant gradually enters the air gap 60 through the through holes 81 and/or 80 and removes the sacrificial layer material in the air gap.

In an embodiment, in the resonator of the present disclosure, the top electrode is a gap electrode, and the first top electrode 50 and the second top electrode 70 are electrically connected with each other at electrode pin ends thereof. The first top electrode 50 and the second top electrode 70 define at least one release channel 81 between electrode non-pin ends thereof (referring to Figs. 1A and 1B).

Referring specifically to Fig. 1B, it is a sectional view of the bulk acoustic wave resonator along a straight line A1-A2 in Fig. 1A. In Fig. 1B, an etching process structure in the first embodiment is utilized, in which an arrow direction indicates that the etchant enters the air gap 60 from the outside through the channels 80 and removes the sacrificial material in the air gap 60. It should be noted that the channel 81 in Fig. 1B may refer to a plurality of partial openings.

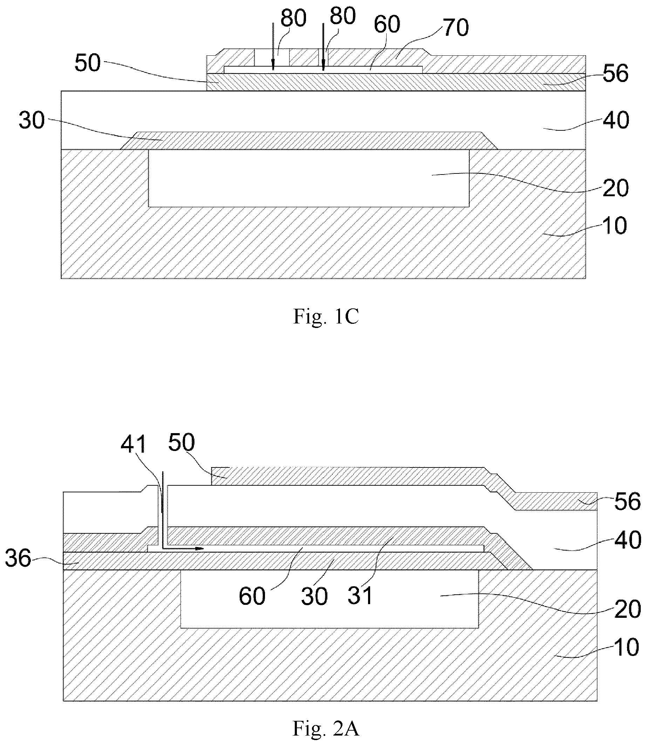

In addition, optionally, Fig. 1C is a sectional view along the straight line A1-A2 in Fig. 1A, and an etching process structure in the second embodiment is utilized. The arrow direction indicates that the etchant enters the air gap 60 from the outside through the channel 80. That is, in the resonator of the present disclosure, the top electrode is a gap electrode, the second electrode 70 is provided with at least one through hole 80, and the at least one through hole constitutes a release channel.

Further optionally, in the process structure of the resonator shown in Fig. 2A, the air gap is located in the bottom electrode, and the through hole 41 penetrates through the piezoelectric layer 40 and the second bottom electrode 31 to enter the air gap 60. The through hole 41 is located outside the acoustic mirror 20 in a lateral direction. During the processing, the etchant gradually enters the air gap 60 through the through hole 41 along the arrow direction in Fig. 2A, and removes the sacrificial material in the air gap 60. In the resonator in the present embodiment of the present disclosure, the bottom electrode is a gap electrode, and the release channel is located outside the effective region in the lateral direction of the resonator and penetrates through the second bottom electrode 31.

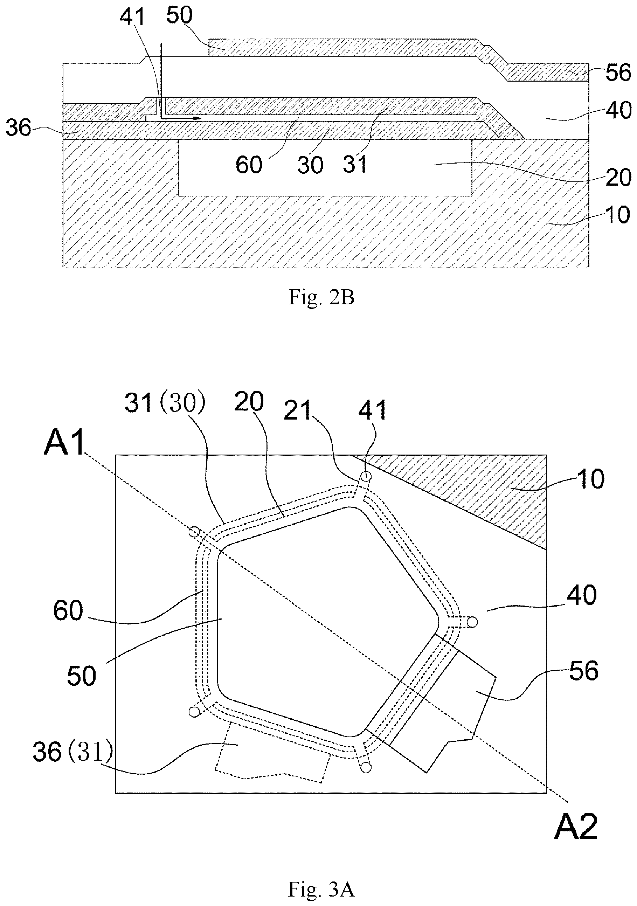

Optionally, the release channel 80 penetrates through the piezoelectric layer 40 and the second bottom electrode 31, as shown in Fig. 2B.

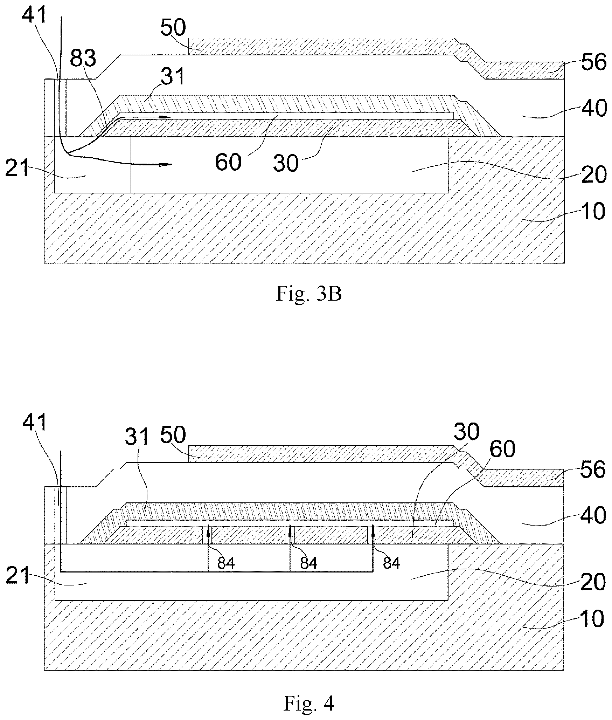

Optionally, as shown in Fig. 3B, a process structure is shown, in which a through hole is only provided in the second bottom electrode 31. Since the piezoelectric layer 40 has a loose micro-structure, and a main component of the etchant is hydrofluoric acid, which is a small molecule/ion. During the processing, the etchant passes through the piezoelectric layer 40, then enters the air gap 60 through the through hole in the second bottom electrode 31, and removes the sacrificial material in the air gap 60. In addition, reaction products also pass through the piezoelectric layer 40 through the through hole to be released into a solution or gas environment outside the resonator.

In the process structure of the resonator shown in Figs. 3A and 3B, Fig. 3B is a sectional view of the process structure of the resonator, in which the bottom electrode is provided with the air gap.

Specifically, the air gap is located in the bottom electrode, and the through hole 41 penetrates through the piezoelectric layer 40 and enters a release channel 21 of the cavity-type acoustic mirror. The through hole 41 is located outside the bottom electrode in the lateral direction. In addition, the first bottom electrode 30 and the second bottom electrode 31 form a channel 83 on a side, and the channel communicates the air gap 60 and the release channel 21 of the cavity 20. During the processing, the etchant gradually enters the air gap 20 and the cavity 60 through paths 41-21 and 41-83 along the arrow direction in Fig. 3A, respectively, and removes the sacrificial material in the air gap 20 and the cavity 60.

In the process structure of the resonator shown in Fig. 4, the air gap is located in the bottom electrode. The first bottom electrode 30 has a plurality of through holes 84, and the through holes 84 communicate the air gap 60 and the cavity 20. During the processing, the etchant enters the cavity 20 through the path 41-21 along the arrow in Fig. 4, and gradually removes the sacrificial material in the cavity 20. As the reaction proceeds, the through holes 84 are exposed. The etchant continues to enter the air gap 60 through the through holes 84, and gradually removes the sacrificial material in the air gap 60.

Therefore, in an embodiment of the present disclosure, the bottom electrode is a gap electrode, and the acoustic mirror 20 includes an acoustic mirror cavity. Further, the release channel includes a first channel (corresponding to the through hole 41) outside the effective region in the lateral direction of the resonator, and the release channel further includes a second channel for communicating the first channel with the gap layer.

Specifically, in the resonator of the present disclosure, the first channel is a first through hole (corresponding to the through hole 41) penetrating through the piezoelectric layer, and the second channel includes a second through hole (corresponding to the through hole 84) penetrating through the second electrode. The first through hole communicates with the acoustic mirror cavity, and the second through channel communicates with the acoustic mirror cavity.

In addition, in the resonator of the present disclosure, the first channel is a first through hole penetrating through the piezoelectric layer, and on a side of the bottom electrode close to the first through hole, an end portion of the first electrode is located above an end portion of the second electrode and the second channel (corresponding to the reference sign 83) is formed between the two end portions.

Based on the above description of the etching steps, the embodiments of the present disclosure also disclose a method for manufacturing the bulk acoustic wave resonator, which includes the following steps:
forming a sacrificial layer material between the first electrode and the second electrode of the gap electrode, wherein the sacrificial layer material is arranged between the first electrode and the second electrode in the thickness direction of the resonator;
providing the release channel; and
etching, by using an etchant, the sacrificial layer material through the release channel to form the gap layer.

As can be appreciated by those skilled in the art, the bulk acoustic wave resonator according to the present disclosure can be used to form a filter.

Based on the above description, the present disclosure also proposes the following technical solutions:
1. A bulk acoustic wave resonator, including:
   a substrate;
   an acoustic mirror;
   a top electrode;
   a bottom electrode; and
   a piezoelectric layer provided between the bottom electrode and the top electrode,
   wherein:
      the top electrode, the bottom electrode, the acoustic mirror and the piezoelectric layer overlap with each other in a thickness direction of the resonator to form an overlapping region, which defines an effective region of the resonator;
      the bottom electrode and/or the top electrode is a gap electrode, the gap electrode includes a first electrode and a second electrode, the first electrode is attached to the piezoelectric layer, a gap layer is provided between the first electrode and the second electrode, and the gap layer is arranged between the first electrode and the second electrode in a height direction of the resonator; and
      the gap electrode is provided with at least one release channel to form the gap layer, the release channel communicates with the gap layer, the release channel includes an electrode channel portion provided in a non-effective region of the electrode.
   2. The resonator according to 1, wherein:
      the top electrode is a gap electrode; and
      the first electrode and the second electrode are electrically connected with each other at electrode pin ends thereof, and at least one electrode channel portion is arranged between an electrode non-pin end of the first electrode and an electrode non-pin end of the second electrode
   3. The resonator according to 1, wherein:
      the top electrode is a gap electrode; and
      the second electrode is provided with at least one through hole, and the through hole constitutes the electrode channel portion.
   4. The resonator according to 1, wherein:
      the bottom electrode is a gap electrode; and
      the electrode channel portion is located outside the effective region in a lateral direction of the resonator and penetrates through the first electrode.
   5. The resonator according to 4, wherein:
      the release channel further includes a piezoelectric layer channel penetrating through the piezoelectric layer, and the piezoelectric layer channel communicates with the electrode channel.
   6. The resonator according to 1, wherein:
      the bottom electrode is a gap electrode;
      the acoustic mirror includes an acoustic mirror cavity; and
      the at least one release channel includes a first channel located outside the effective region in a lateral direction of the resonator, and the at least one release channel further includes a second channel communicating the first channel with the gap layer.
   7. The resonator according to 6, wherein:
      the first channel is a first through hole penetrating through the piezoelectric layer; and
      the second channel includes at least one second through hole penetrating through the second electrode, the first through hole communicates with the acoustic mirror cavity, the at least one second through hole communicates with the acoustic mirror cavity, and the electrode channel portion includes the at least one second through hole.
   8. The resonator according to 6, wherein:
      the first channel is a first through hole penetrating through the piezoelectric layer; and
      on a side of the bottom electrode close to the first through hole, an end portion of the first electrode is located above an end portion of the second electrode, and the second channel is formed between the end portion of the first electrode and the end portion of the second electrode.
   9. The resonator according to 8, wherein:
      the second channel communicates with the acoustic mirror cavity.
   10. A filter, including the bulk acoustic wave resonator according to any one of 1-9.
   11. An electronic device, including the bulk acoustic wave resonator according to any one of 1-9 or the filter according to 10.

It should be pointed out that, in the present disclosure, the electrode channel portion is arranged in the non-effective region of the electrode, and the non-effective region of the electrode refers to a portion of the electrode that does not participate in forming the effective region. For example, in Fig. 1C, although a projection of a portion where the through holes 80 are provided in the additional electrode (the second top electrode) is located within the effective region in the thickness direction of the resonator, this portion is not a constituent portion for forming the effective region. Thus, the non-effective region of the electrode includes a first electrode portion located in the non-effective region and/or the second electrode, that is, an electrode portion that does not substantially participate in the main resonance of the effective region of the resonator.

Although the embodiments of the present disclosure have been shown and described, it will be understood by those skilled in the art that changes can be made to these embodiments without departing from the principles and spirit of the present disclosure, and the scope of the present disclosure is determined by the appended claims and their equivalents.

## Claims

1. A bulk acoustic wave resonator, comprising:
a substrate;
an acoustic mirror;
a top electrode;
a bottom electrode; and
a piezoelectric layer provided between the bottom electrode and the top electrode,
wherein the top electrode, the bottom electrode, the acoustic mirror and the piezoelectric layer overlap with each other in a thickness direction of the resonator to form an overlapping region, and the overlapping region defines an effective region of the resonator;
wherein the bottom electrode and/or the top electrode is a gap electrode, the gap electrode comprises a first electrode and a second electrode, the first electrode is attached to the piezoelectric layer, a gap layer is provided between the first electrode and the second electrode, and the gap layer is located between the first electrode and the second electrode in a height direction of the resonator; and
wherein the gap electrode is provided with at least one release channel to form the gap layer, the at least one release channel communicates with the gap layer, the at least one release channel comprises an electrode channel portion provided in a non-effective region of the gap electrode.

2. The resonator according to claim 1, wherein the top electrode is a gap electrode; and the first electrode and the second electrode are electrically connected with each other at electrode pin ends thereof, and at least one the electrode channel portion is arranged between an electrode non-pin end of the first electrode and an electrode non-pin end of the second electrode.

3. The resonator according to claim 1 or 2, wherein the top electrode is a gap electrode; and
the second electrode is provided with at least one through hole, and the at least one through hole constitutes the electrode channel portion.

4. The resonator according to claim 1, wherein the bottom electrode is a gap electrode; and the electrode channel portion is located outside the effective region in a lateral direction of the resonator and penetrates through the first electrode.

5. The resonator according to claim 4, wherein the at least one release channel further comprises a piezoelectric layer channel penetrating through the piezoelectric layer, and the piezoelectric layer channel communicates with the electrode channel.

6. The resonator according to claim 1, wherein the bottom electrode is a gap electrode;
the acoustic mirror comprises an acoustic mirror cavity; and
the at least one release channel comprises a first channel located outside the effective region in a lateral direction of the resonator, and the at least one release channel further comprises a second channel communicating the first channel with the gap layer.

7. The resonator according to claim 6, wherein the first channel is a first through hole penetrating through the piezoelectric layer; and
the second channel comprises at least one second through hole penetrating through the second electrode, the first through hole communicates with the acoustic mirror cavity, the at least one second through hole communicates with the acoustic mirror cavity, and the electrode channel portion comprises the at least one second through hole.

8. The resonator according to claim 6, wherein the first channel is a first through hole penetrating through the piezoelectric layer;
on a side of the bottom electrode close to the first through hole, an end portion of the first electrode is located above and an end portion of the second electrode, and the end portion of the first electrode and the end portion of the second electrode are spaced apart from each other to form a hole channel therebetween; and
the second channel comprises the hole channel, and the electrode channel portion comprises the hole channel.

9. The resonator according to claim 8, wherein the second channel communicates with the acoustic mirror cavity.

10. A filter, comprising the bulk acoustic wave resonator according to any one of claims 1-9.

11. An electronic device, comprising the bulk acoustic wave resonator according to any one of claims 1-9 or the filter according to claim 10.

12. A method for manufacturing the bulk acoustic wave resonator according to any one of claims 1-9, comprising:
forming a sacrificial layer material between the first electrode and the second electrode, the sacrificial layer material being arranged between the first electrode and the second electrode in the thickness direction of the resonator;
providing the at least one release channel; and
etching, by using an etchant, the sacrificial layer material through the at least one release channel to form the gap layer.
